# EUROPEAN PATENT APPLICATION

(11) **EP 4 411 021 A1**
(43) Date of publication of application: **07.08.2024**
(21) Application number: 22875689.6
(22) Date of filing: 30.08.2022
(51) Int. Cl.: C23C 16/40, C30B 29/22, H01L 21/365, H01L 21/368

(54) **LAMINATED STRUCTURE, SEMICONDUCTOR DEVICE, AND METHOD FOR FORMING CRYSTALLINE OXIDE FILM**

(30) Priority: 30.09.2021 JP 2021160824
(71) Applicant: SHIN-ETSU CHEMICAL CO., LTD., Tokyo 1000005 (JP)
(72) Inventor: WATABE, Takenori, Annaka-shi, Gunma 379-0195 (JP); HASHIGAMI, Hiroshi, Annaka-shi, Gunma 379-0195 (JP); SAKATSUME, Takahiro, Annaka-shi, Gunma 379-0195 (JP)
(74) Representative: Mooser, Sebastian Thomas
(86) International application number: PCT/JP2022/032495
(87) International publication number: WO 2023/053817

(57) **Abstract**

The present invention is a laminated structure having at least a base substrate and a crystalline oxide film containing gallium oxide as a main component, wherein an average value of reflectance of light having a wavelength of 400 to 800 nm is 16% or greater on a surface on a side of the crystalline oxide film of the laminated structure. Thus, the present invention provides a laminated structure having a crystalline oxide film containing gallium oxide as a main component with extremely few crystal defects, excellent crystallinity, and excellent semiconductor properties when applied to a semiconductor device.

## Description

### TECHNICAL FIELD

The present invention relates to: a laminated structure having a base substrate and a crystalline oxide film containing gallium oxide as a main component; a semiconductor device; and a method of forming a crystalline oxide film.

### BACKGROUND ART

In recent years, gallium oxide (Ga₃O₃) has attracted attention as a material for a semiconductor. It is known that gallium oxide has five crystal forms: α, β, γ, δ, and ε. Among them, α-Ga₂O₃ is a metastable phase with very wide bandgap of 5.3 eV, and is a promising material for a power semiconductor.

For example, Patent Document 1 discloses a semiconductor device including a base substrate having a corundum-type crystal structure, a semiconductor layer having a corundum-type crystal structure, and an insulating film having a corundum-type crystal structure, and describes an example where an α-Ga₂O₃ film is formed as a semiconductor layer on a sapphire substrate. Additionally, Patent Document 2 discloses a semiconductor device equipped with an n-type semiconductor layer containing a crystalline oxide semiconductor having a corundum structure as a main component, a p-type semiconductor layer containing an inorganic compound having a hexagonal crystal structure as a main component, and an electrode. Patent Document 2 discloses, in Examples, fabrication of a diode by forming an α-Ga₂O₃ film having a metastable phase corundum structure as an n-type semiconductor layer and an α-Rh₂O₃ film having a hexagonal crystal structure as a p-type semiconductor layer on a c-plane sapphire substrate.

However, since α-Ga₂O₃ is a metastable phase, a single crystal substrate is not in practical use and generally formed by heteroepitaxial growth on a sapphire substrate or the like. In such cases, stress is applied to a semiconductor film due to difference in lattice constants from that of sapphire, that may form a large number of crystal defects or cause warping of the semiconductor film.

To reduce crystal defects in α-Ga₂O₃, a method has been reported to form a buffer layer between sapphire and an α-Ga₂O₃ layer. For example, Non Patent Document 1 describes an example where a (Alₓ, Ga₁₋ₓ)₂O₃ layer (x = 0.2 to 0.9) is introduced as a buffer layer between sapphire and an α-Ga₂O₃ layer, such that edge dislocation and screw dislocation are 3 × 10⁸/cm² and 6 × 10⁸/cm², respectively.

### CITATION LIST

### PATENT LITERATURE

Patent Document 1: JP 2014-72533 A
Patent Document 2: JP 2016-25256 A
Patent Document 3: JP 2016-157878 A

### NON PATENT LITERATURE

Non Patent Document 1: Riena Jinno et al., Reduction IN edge dislocation density IN corundum-structured α-Ga2O3 layers on sapphire substrates with quasi-graded α-(Al, Ga)2O3 buffer layers, Applied Physics Express, Japan, tHE Japan Society of Applied Physics, June 1, 2016, vol.9, pages 071101-1 to 071101-4

### SUMMARY OF INVENTION

### TECHNICAL PROBLEM

However, when using a crystalline oxide film containing gallium oxide as a main component, such as an α-Ga₂O₃ film, for a power semiconductor or the like which requires high withstand voltage, breakdown electric field properties depend on the amount of crystal defects. Hence, further reduction of the crystal defects is desired. Additionally, the α-Ga₂O₃ film may become a so-called mosaic crystal in which there are regions (domains) with a slightly different tilt (inclination of a crystal axis in growth direction) or twist (rotation of the crystal axis within a surface plane). One of the reasons for this is considered to be that the α-Ga₂O₃ layer is a metastable phase and thus has relatively low deposition temperature. However, when using for a power semiconductor or the like, the presence of grain boundaries between the domains may deteriorate the breakdown electric field properties, and thus, prevention of domain formation is also desired. Patent Document 3 discloses that by providing a buffer layer having a quantum well structure, rotation domains of the α-Ga₂O₃ film are reduced and crystallinity is improved though the effects thereof are not sufficient.

The present invention has been made to solve the above-mentioned problems, and the present invention aims to provide: a laminated structure having a crystalline oxide film containing gallium oxide as a main component, wherein the crystalline oxide film has extremely few crystal defects, excellent crystallinity, and excellent semiconductor properties when applied to a semiconductor device; a semiconductor device; and a method of forming the crystalline oxide film.

### SOLUTION TO PROBLEM

To achieve the object, the present invention provides a laminated structure having at least a base substrate and a crystalline oxide film containing gallium oxide as a main component, wherein an average value of reflectance of light having a wavelength of 400 to 800 nm is 16% or greater on a surface on a side of the crystalline oxide film of the laminated structure.

The crystalline oxide film constituting such laminated structure has extremely few crystal defects, excellent crystallinity, and excellent semiconductor properties when applied to a semiconductor device.

In this laminated structure, the base substrate can be a single crystal, and the crystalline oxide film can be a single crystal or a uniaxially oriented film.

This enables a laminated structure having a crystalline oxide film with better crystallinity.

In this laminated structure, the base substrate can be any of a sapphire substrate, a lithium tantalate substrate, or a lithium niobate substrate.

This enables a laminated structure having a crystalline oxide film which is industrially inexpensive and has excellent crystallinity.

In this laminated structure, the crystalline oxide film can have a corundum structure.

The laminated structure according to the present invention is suitable for a crystalline oxide film having such corundum structure.

In this laminated structure, the crystalline oxide film having the corundum structure can have a half width of an x-ray rocking curve of a (006) plane of 5 to 20 seconds.

Accordingly, the crystalline oxide film containing gallium oxide as a main component according to the present invention enables a laminated structure having a crystalline oxide film with better crystallinity.

In this laminated structure, the base substrate can have a surface area of 100 mm² or more having the crystalline oxide film, or a diameter of 2 inches (50 mm) or more.

This enables a laminated structure having a crystalline oxide film with a large area and excellent crystallinity.

The present invention further provides: a method of forming a crystalline oxide film containing gallium oxide as a main component by Mist CVD, including supplying a carrier gas containing mist from a nozzle to a base substrate placed in a deposition chamber, wherein the film is formed with temperature of the nozzle or an inner wall of the deposition chamber higher than a room temperature.

This can provide a crystalline oxide film with extremely few crystal defects, excellent crystallinity, and excellent semiconductor properties when applied to a semiconductor device.

In this case, the temperature of the nozzle can be 50 to 250°C.

This can provide a crystalline oxide film with better crystallinity.

The present invention further provides: a semiconductor device including a crystalline oxide film as an insulating thin film or a conductive thin film, the crystalline oxide film containing gallium oxide as a main component, wherein an average value of reflectance of light having a wavelength of 400 to 800 nm is 16% or greater on a surface on a side of the crystalline oxide film.

Such crystalline oxide film has extremely few crystal defects and excellent crystallinity, enabling a semiconductor device with excellent semiconductor properties such as high breakdown voltage.

### ADVANTAGEOUS EFFECTS OF INVENTION

As described above, according to the laminated structure of the present invention, it is possible to obtain a laminated structure having a crystalline oxide film with extremely few crystal defects, excellent crystallinity, and excellent semiconductor properties when applied to a semiconductor device. Additionally, according to the method of forming a crystalline oxide film of the present invention, it is possible to obtain a crystalline oxide film with extremely few crystal defects, excellent crystallinity, and excellent semiconductor properties when applied to a semiconductor device. Further, according to the semiconductor device of the present invention, it is possible to obtain a semiconductor device with excellent semiconductor properties such as high breakdown voltage.

### BRIEF DESCRIPTION OF DRAWINGS

FIG. 1 is a diagram showing one example of a reflectance spectrum of a laminated structure according to Example 1 and Comparative Example 1;
FIG. 2 is a diagram showing one example of a reflectance spectrum of a laminated structure according to Example 2;
FIG. 3 is a diagram showing one example of a reflectance spectrum of a laminated structure according to Example 3;
FIG. 4 is a schematic illustration of a configuration showing one example of a semiconductor device using the laminated structure according to the present invention;
FIG. 5 is a schematic illustration of a configuration showing one example of a deposition apparatus (Mist CVD apparatus) suitably used for deposition of the laminated structure according to the present invention;
FIG. 6 is a diagram explaining one example of a mist generating unit used for the present invention;
FIG. 7 is a diagram showing one example of a reflectance spectrum of a laminated structure according to Example 4;
FIG. 8 is a diagram showing one example of a reflectance spectrum of a laminated structure according to Example 5; and
FIG. 9 is a diagram showing one example of a reflectance spectrum of a laminated structure according to Comparative Example 2.

### DESCRIPTION OF EMBODIMENTS

Hereinafter, the present invention will be described in detail, but the present invention is not limited thereto.

As described above, it has been demanded: a laminated structure having a crystalline oxide film containing gallium oxide as a main component, wherein the crystalline oxide film has extremely few crystal defects, excellent crystallinity, and excellent semiconductor properties when applied to a semiconductor device; a semiconductor device; and a method of forming the crystalline oxide film.

As a result of intensive studies on the above problems, the present inventors have found that a crystalline oxide film with extremely few crystal defects, excellent crystallinity, and excellent semiconductor properties when applied to a semiconductor device can be achieved by a laminated structure having at least a base substrate and a crystalline oxide film containing gallium oxide as a main component, wherein an average value of reflectance of light having a wavelength of 400 to 800 nm is 16% or greater on a surface on a side of the crystalline oxide film of the laminated structure, and completed the present invention.

Additionally, the present inventors have found that a crystalline oxide film with extremely few crystal defects, excellent crystallinity, and excellent semiconductor properties when applied to a semiconductor device can be obtained by a method of forming a crystalline oxide film containing gallium oxide as a main component by Mist CVD, including supplying a carrier gas containing mist from a nozzle to a base substrate placed in a deposition chamber, wherein the film is formed with temperature of the nozzle or an inner wall of the deposition chamber higher than a room temperature, and completed the present invention.

Further, the present inventors have found a semiconductor device including a crystalline oxide film as an insulating thin film or a conductive thin film, the crystalline oxide film containing gallium oxide as a main component, wherein an average value of reflectance of light having a wavelength of 400 to 800 nm is 16% or greater on a surface on a side of the crystalline oxide film, thereby enabling a semiconductor device with excellent semiconductor properties such as high breakdown voltage, and completed the present invention.

Hereinafter, the present invention will be described with reference to the drawings.

### (Laminated Structure)

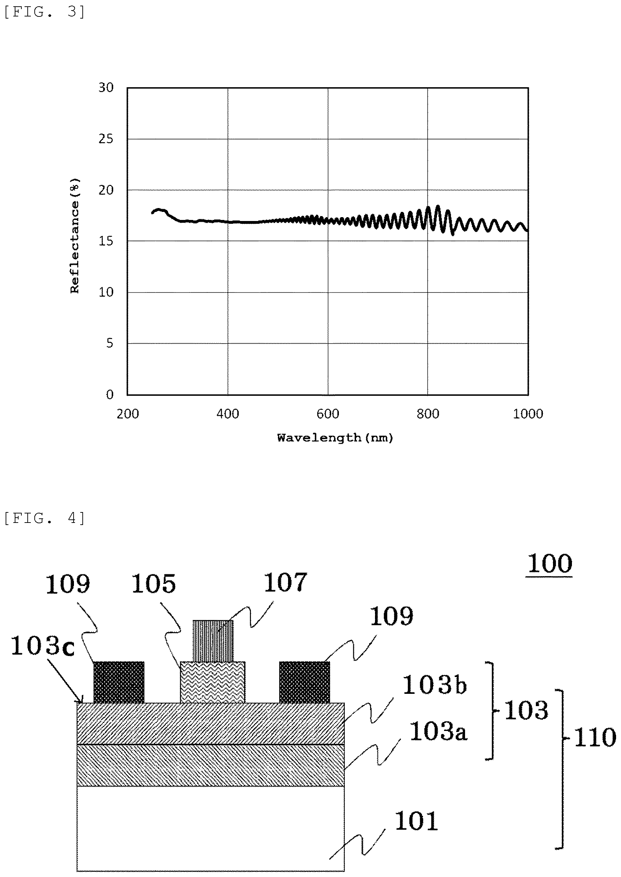

FIG. 4 shows a suitable example of a semiconductor device 100 utilizing a laminated structure 110 according to the present invention. The laminated structure 110 according to the present invention has a base substrate 101 and a crystalline oxide film 103 containing at least gallium oxide as a main component, as shown in FIG. 4. Further, an average value of reflectance of light having a wavelength of 400 to 800 nm is 16% or greater on a surface 103c on a side of the crystalline oxide film.

This enables extremely few crystal defects, excellent crystallinity, and excellent semiconductor properties when applied to a semiconductor device. It is considered that the reflectance reflects a refractive index of the produced crystalline oxide film. When the reaction is incomplete, hydroxy groups and the like remain in the film and reduces the refractive index, resulting in decreased reflectance. On the other hand, when an ideal reaction occurs, unintended hydroxy groups no longer exist in the film and the refractive index of the film increases, resulting in higher reflectance of the laminated structure. This state means that the reflectance of the laminated structure is higher than the reflectance in a case that the film is removed and only the substrate is left.

Here, features specified by the reflectance of light in the laminated structure according to the present invention will be described. The wavelength range of 400 to 800 nm of reflected light is a range in which the spectrum changes relatively slowly, and by adopting the average value of such wavelength range of the reflected light, it is possible to evaluate the crystallinity of the film stably and accurately. Since the refractive index of gallium oxide is about 2.0 when the ideal reaction occurs, an upper limit of the reflectance is expected to be about 19%. On the other hand, the refractive index of gallium oxide is less than 2.0 when the reaction is incomplete, and the reflectance also decreases accordingly. A case that the reflectance is 16% or less corresponds to a case that the refractive index is 1.9 or less, where the crystallinity is worse and expected properties of gallium oxide cannot be obtained. Accordingly, when the average value of reflectance of light having a wavelength of 400 to 800 nm is high, residues such as hydroxy groups in the film are suppressed, resulting in extremely few crystal defects and excellent crystallinity. This indicates that the ideal reaction of film formation has been performed.

It should be noted that the upper limit of the reflectance also depends on the base substrate as described later. When the base substrate is sapphire, the upper limit of the reflectance is about 19% as described above, whereas when the base substrate is lithium tantalate, the upper limit of the reflectance is about 35%.

The reflectance can be obtained by calculation based on a measurement result of a reflectance spectrum by a spectrophotometer, for example. The reflectance includes specular reflectance and diffuse reflectance, as well as total reflectance which is obtained by measuring the both. Though any of them can be used, it is preferable to evaluate using the total reflectance. This is because it is less susceptible to surface conditions due to difference in deposition conditions, such as surface unevenness.

The spectrophotometer has at least an integrating sphere to detect light reflected from a sample. For the total reflectance, the sample is irradiated with light at an incident angle of about 10 degrees or less, and not only diffuse reflected light but also specular reflected light are measured with the integrating sphere. When measuring, baseline measurement is performed first. The baseline is obtained by measuring the reflectance with a white reflectance standard such as barium sulfate attached to the integrating sphere. Once the baseline is obtained, the white reflectance standard is removed and the sample is attached so that the reflectance spectrum can be measured.

Another layer may be interposed between a substrate and a crystalline oxide film. Another layer is a layer having a different composition from those of the substrate and the outermost crystalline oxide film, and also referred to as a buffer layer. The buffer layer may be any of a crystalline oxide film, a semiconductor film, an insulating film, a metal film or the like, and Al₂O₃, Ga₂O₃, Cr₂O₃, Fe₂O₃, In₂O₃, Rh₂O₃, V₂O₃, Ti₂O₃, Ir₂O₃ or the like are suitably used as a material, for example. Thickness of the buffer layer is preferably 0.1 um to 2 µm.

### (Base Substrate)

The base substrate in the laminated structure according to the present invention is not particularly limited as long as it can be a support of the crystalline oxide film described above. The material is not particularly limited, and a known substrate can be used; it may be an organic compound or an inorganic compound. Examples thereof include polysulfone, polyethersulfone, polyphenylene sulfide, polyetheretherketone, polyimide, polyetherimide, fluororesin, metals such as iron, aluminum, stainless steel, and gold, quartz, glass, calcium carbonate, gallium oxide, ZnO, and the like. In addition to these, it includes a single crystal substrate such as silicon, sapphire, lithium tantalate, lithium niobate, SiC, GaN, iron oxide, chromium oxide, and the like. In the laminated structure according to the present invention, the single crystal substrates as described above are preferable. These can provide a higher-quality crystalline oxide film. Particularly, a sapphire substrate, a lithium tantalate substrate, and a lithium niobate substrate are relatively inexpensive and industrially advantageous.

Thickness of the base substrate is preferably 100 to 5,000 um. Within this range, handling is easy and thermal resistance can be suppressed during deposition, making it easier to obtain a high-quality film.

Although size of the base substrate is not particularly limited, a surface area of the base substrate where the crystalline oxide film is formed is preferably 100 mm² or more, or the diameter thereof is preferably 2 inches (50 mm) or more so that a film having a large area and excellent crystallinity can be obtained. Although an upper limit of the area of the base substrate is not particularly limited, it can be 100,000 mm² or smaller.

### (Crystalline Oxide Film)

The crystalline oxide film in the laminated structure according to the present invention is a crystalline oxide film containing gallium oxide as a main component. Generally, an oxide film consists of metal and oxygen, but in the crystalline oxide film in the laminated structure according to the present invention, it is sufficient to contain gallium as a main component of metal. It should be noted that in the present invention, "containing gallium as a main component" means that 50 to 100% of a metal component is gallium. As the metal component other than gallium, one kind or two or more kinds of metals selected from iron, indium, aluminum, vanadium, titanium, chromium, rhodium, iridium, nickel, and cobalt may be contained, for example.

The crystalline oxide film may contain a dopant element. Examples thereof include, but not specifically limited to, an n-type dopant such as tin, germanium, silicon, titanium, zirconium, vanadium, or niobium, or a p-type dopant such as copper, silver, tin, iridium, rhodium, or magnesium. Concentration of the dopant may be, for example, about 1 × 10¹⁶/cm³ to 1 × 10²²/cm³, or as low as about 1 × 10¹⁷/cm³ or less, or as high as about 1 × 10²⁰/cm³ or more.

A crystal structure of the crystalline oxide film is not particularly limited, and may be a β-gallia structure, a corundum structure, or an orthorhombic crystal. Although it may be a plurality of crystal structures mixed or a polycrystal, it is preferably a single crystal or a uniaxially oriented film. Whether it is a single crystal or a uniaxially oriented film can be confirmed by an x-ray diffraction apparatus, an electron diffraction apparatus, or the like. When irradiating the film with x-rays or electron beams, a diffraction image corresponding to the crystal structure is obtained, where only a specific peak appears if the film is uniaxially oriented. Accordingly, it can be determined as being uniaxially oriented. Additionally, the crystalline oxide film according to the present invention preferably has a corundum structure. In this case, a half width of an x-ray diffraction rocking curve of a (006) plane can be 5 to 20 seconds.

Although film thickness of the crystalline oxide film is not particularly limited, it is preferably 1 um or more. An upper limit thereof is not particularly limited. For example, it may be 100 um or less, preferably can be 50 um or less, and more preferably can be 20 um or less.

### (Semiconductor Device)

The semiconductor device according to the present invention has a crystalline oxide film as an insulating thin film or a conductive thin film, the crystalline oxide film containing gallium oxide as a main component. Further, an average value of reflectance of light having a wavelength of 400 to 800 nm is 16% or greater on a surface on a side of the crystalline oxide film. Such crystalline oxide film has extremely few crystal defects and excellent crystallinity, enabling a semiconductor device having excellent semiconductor properties such as high breakdown voltage.

### (Configuration Example of Semiconductor Device)

In the example of the semiconductor device 100 shown in FIG. 4, the crystalline oxide film 103 is formed on the base substrate 101. The crystalline oxide film 103 is configured with an insulating thin film 103a and a conductive thin film 103b sequentially laminated from the side of the base substrate 101. A gate insulating film 105 is formed on the conductive thin film 103b. A gate electrode 107 is formed on the gate insulating film 105. Additionally, on the conductive thin film 103b, a source/drain electrode 109 is formed to sandwich the gate electrode 107. According to such configuration, gate voltage to be applied to the gate electrode 107 enables control of a depletion layer formed in the conductive thin film 103b, as well as transistor operation (FET device).

The semiconductor device formed using the laminated structure according to the present invention includes a transistor and TFT such as MIS, HEMT, and IGBT, a schottky barrier diode utilizing semiconductor-metal junction, a PN or PIN diode combined with other P layers, and a light receiving/emitting element. The laminated structure according to the present invention is useful for improving properties of these devices.

The laminated structure as described above can be formed by a known method such as a vapor deposition method, an MBE method, a sputtering method, a CVD method, Mist CVD, and liquid-phase epitaxy.

Hereinafter, a method of manufacturing the laminated structure according to the present invention will be described citing Mist CVD as an example. In the present invention, mist herein refers to a general term for fine liquid particles dispersed in gas, and includes what is called fog, droplets, and the like.

### (Deposition Apparatus)

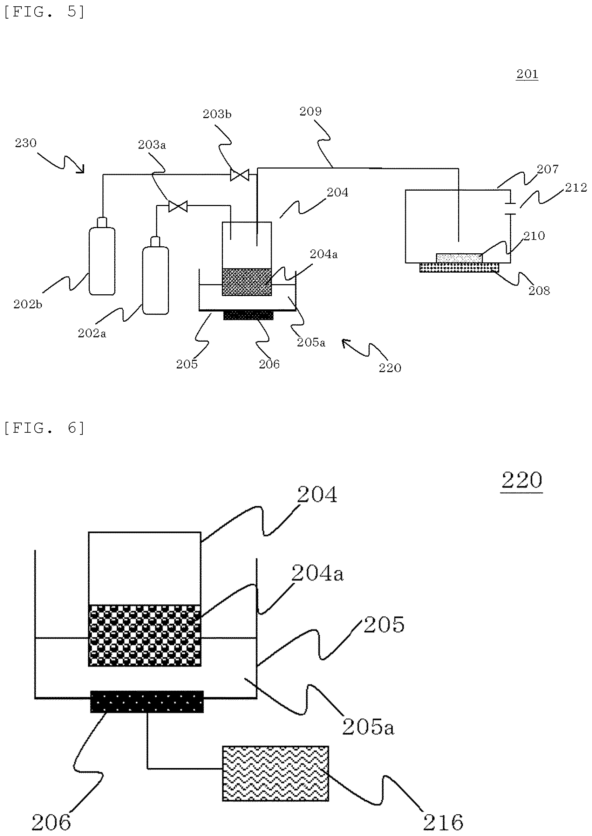

First, a deposition apparatus (Mist CVD apparatus) used for Mist CVD, which is suitable for manufacturing the laminated structure according to the present invention, will be described. FIG. 5 shows one example of a deposition apparatus 201 used for Mist CVD. The deposition apparatus 201 has at least a mist generating unit 220 which generates mist by atomizing a raw material solution 204a into mist, a carrier gas supply unit 230 which supplies a carrier gas to deliver the mist, a supply pipe 209 which connects the mist generating unit 220 with a deposition chamber 207, through which the mist is delivered by the carrier gas, and the deposition chamber 207 which performs heat treatment of the mist supplied from the supply pipe 209 together with the carrier gas, thereby forming a film on a base substrate 210.

### (Mist Generating Unit)

In the mist generating unit 220, the raw material solution 204a is atomized into mist to generate the mist. A mist generating technique is not particularly limited as long as the raw material solution 204a can be atomized into mist, and may be a known mist generating technique. It is preferable to use a mist generating technique by ultrasonic vibration. This is because it allows more stable atomization into mist.

FIG. 6 shows one example of such mist generating unit 220. The mist generating unit 220 may include a mist source 204 in which the raw material solution 204a is stored, a container 205 in which a medium such as water 205a capable of transferring ultrasonic vibration can be accommodated, and an ultrasonic transducer 206 attached to a bottom surface of the container 205. In detail, the mist source 204 consisting of a container in which the raw material solution 204a is stored can be housed, using a support (not shown), in the container 205 in which the water 205a is stored. At a bottom of the container 205, the ultrasonic transducer 206 may be installed, and the ultrasonic transducer 206 and an oscillator 216 may be connected to each other. Then, it is possible to configure such that when the oscillator 216 is activated, the ultrasonic transducer 206 vibrates to propagate ultrasonic waves through the water 205a into the mist source 204, and the raw material solution 204a is atomized into mist.

### (Raw Material Solution)

The raw material solution 204a contains gallium. Materials contained in the solution are not particularly limited as long as they can be atomized into mist, and may be inorganic materials or organic materials. As the contained materials other than gallium, metal or a metal compound is suitably used. For example, those containing one kind or two or more kinds of metals selected from iron, indium, aluminum, vanadium, titanium, chromium, rhodium, nickel, and cobalt may be used. As the raw material solution described above, metal dissolved or dispersed in an organic solvent or water in a form of complexes or salts can be suitably used. Examples of the form of the salts include halide salts or the like, such as metal chloride salts, metal bromide salts, and metal iodide salts. Additionally, a solution obtained by dissolving the above metal in hydrogen halide or the like, such as hydrobromic acid, hydrochloric acid, and hydroiodic acid, can also be used as a salt solution. Examples of the form of the complexes include acetylacetonate complexes, carbonyl complexes, ammine complexes, hydride complexes, and the like. By mixing acetylacetone with the aforementioned salt solution, acetylacetonato complexes can also be formed. Concentration of the metal in the raw material solution 204a is not particularly limited and can be 0.005 to 1 mol/L, for example. Temperature during mixing and dissolving is preferably 20°C or higher.

An additive such as hydrohalic acid and an oxidizing agent may be mixed with the raw material solution. Examples of the hydrohalic acid include hydrobromic acid, hydrochloric acid, hydroiodic acid, and the like, among which hydrobromic acid or hydroiodic acid is preferable. Examples of the oxidizing agent include peroxides such as hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, ozone water, organic peroxides such as peracetic acid and nitrobenzene, and the like.

The raw material solution may contain a dopant. The dopant is not specifically limited. Examples thereof include an n-type dopant such as tin, germanium, silicon, titanium, zirconium, vanadium, or niobium, a p-type dopant such as copper, silver, iridium, rhodium, or magnesium, or the like.

### (Carrier Gas Supply Unit)

As shown in FIG. 5, the carrier gas supply unit 230 has a carrier gas source 202a which supplies a carrier gas. In this case, a flow control valve 203a for adjusting a flow rate of the carrier gas sent out from the carrier gas source 202a may be provided. Additionally, a carrier gas source 202b for dilution which supplies a carrier gas for dilution and a flow control valve 203b for adjusting a flow rate of the carrier gas for dilution which is sent out from the carrier gas source 202b for dilution can also be provided as necessary.

A type of the carrier gas is not particularly limited and can be selected as appropriate according to a film to be formed. Examples thereof include oxygen, ozone, an inert gas such as nitrogen or argon, a reducing gas such as hydrogen gas or forming gas, and the like. Additionally, the type of the carrier gas may be one, or two or more. For example, a dilution gas or the like may be further used as a second carrier gas, which is obtained by diluting the same gas as a first carrier gas with another gas (for example, diluted 10 times), or air can also be used. The flow rate of the carrier gas is not particularly limited. For example, when forming a film on a substrate having a diameter of 2 inches (about 50 mm), the flow rate of the carrier gas is preferably 0.05 to 50 L/min, and more preferably 5 to 20 L/min.

### (Supply Pipe)

The deposition apparatus 201 has the supply pipe 209 which connects the mist generating unit 220 with the deposition chamber 207. In this case, the mist is delivered by the carrier gas from the mist source 204 of the mist generating unit 220 through the supply pipe 209, and supplied to the deposition chamber 207. As the supply pipe 209, a quartz or glass pipe, a resin tube, or the like can be used, for example.

### (Deposition Chamber)

The substrate 210 is placed inside the deposition chamber 207, and a heater 208 for heating the substrate 210 can be provided. The heater 208 may be provided outside the deposition chamber 207 as shown in FIG. 5 or inside the deposition chamber 207. The mist supplied from the supply pipe 209 passes through piping inside the deposition chamber 207 and is ejected together with the carrier gas from a nozzle toward the substrate 210. In addition, the deposition chamber 207 may be provided with an exhaust port 212 for an exhaust gas at a position that does not affect the mist supply to the substrate 210. Further, face-down such as placing the substrate 210 on a top surface of the deposition chamber 207 or face-up such as placing the substrate 210 on a bottom surface of the deposition chamber 207 may be applied.

### (Deposition Method)

Next, one example of the method of manufacturing the laminated structure according to the present invention will be described with reference to FIGS. 5 and 6. In brief, Mist CVD consists of steps, including: a step of generating mist by atomizing a raw material solution containing gallium into mist in a mist generating unit; a step of supplying a carrier gas for delivering the mist to the mist generating unit; a step of delivering the mist by the carrier gas from the mist generating unit to a deposition chamber via a supply pipe which connects the mist generating unit with the deposition chamber; and a step of forming a film on a base substrate by subjecting the delivered mist to heat treatment.

The mixed raw material solution 204a as described above is stored in the mist source 204, the substrate 210 is placed in the deposition chamber 207, and the heater 208 is activated. Next, the flow control valves 203a, 203b are opened to supply the carrier gases from the carrier gas sources 202a, 202b into the deposition chamber 207. After sufficiently replacing an atmosphere in the deposition chamber 207 with the carrier gases, the flow rate of the carrier gas and the flow rate of the carrier gas for dilution are respectively adjusted.

Next, as the step of generating mist, the ultrasonic transducer 206 is vibrated and the vibration thereof propagates through the water 205a to the raw material solution 204a, thereby atomizing the raw material solution 204a into mist to generate the mist.

Next, as the step of supplying a carrier gas, a carrier gas for delivering the mist is supplied to the mist generating unit 220.

Next, as the step of delivering, the mist is delivered by the carrier gas from the mist generating unit 220 to the deposition chamber 207 via the supply pipe 209 which connects the mist generating unit 220 with the deposition chamber 207.

Next, as the step of forming a film, the mist delivered to the deposition chamber 207 is heated to cause thermal reaction, thereby forming a film on a part or all of a surface of the substrate 210.

In the thermal reaction, it is necessary to proceed reaction of gallium and the like contained in the mist by heating. Therefore, temperature of the substrate surface during the reaction should be at least 400°C or higher. In Mist CVD, unlike other CVD methods, it is required to reach a raw material in a mist-like liquid state to the substrate surface. Therefore, the temperature of the substrate surface greatly decreases. Accordingly, the temperature of the substrate surface during the reaction is different from temperature set in the apparatus. It is preferable to measure and control the temperature of the substrate surface during the reaction, but if this is difficult, alternatively, it is possible to simulate the reaction and measure the temperature by introducing only the carrier gas or introducing water mist containing no solute, etc.

Further, the thermal reaction also depends on temperature of environment around the substrate. Accordingly, when supplying the carrier gas containing mist from a nozzle to the base substrate placed in the deposition chamber and forming a crystalline oxide film containing gallium oxide as a main component by Mist CVD, the film is formed with temperature of the nozzle or an inner wall of the deposition chamber higher than a room temperature. This is because the thermal reaction can be stabilized. For example, the temperature of the nozzle is preferably 50 to 250°C. This can provide a crystalline oxide film with better crystallinity.

It should be noted that the thermal reaction may be carried out in any of an atmosphere including vacuum, a non-oxygen atmosphere, a reducing gas atmosphere, an air atmosphere, and an oxygen atmosphere, and may be set as appropriate according to a film to be formed. In addition, reaction pressure may be under any of conditions including atmospheric pressure, increased pressure, or reduced pressure, but deposition under atmospheric pressure is preferable because it enables simplification of the apparatus configuration.

### (Formation of Buffer Layer)

As described above, the buffer layer may be provided between the substrate and the crystalline oxide film as appropriate. A method of forming the buffer layer is not particularly limited, and a known method such as sputtering and vapor deposition methods can be used for deposition. When using Mist CVD as described above, it can be simply and easily formed by only changing the raw material solution as appropriate. Specifically, one kind or two or more kinds of metals selected from aluminum, gallium, chromium, iron, indium, rhodium, vanadium, titanium, and iridium are dissolved or dispersed in water in a form of complexes or salts, which can be suitably used as a raw material aqueous solution. Examples of the form of the complexes include acetylacetonate complexes, carbonyl complexes, ammine complexes, hydride complexes, and the like. Examples of the form of the salts include metal chloride salts, metal bromide salts, metal iodide salts, and the like. Additionally, a solution obtained by dissolving the above metals in hydrobromic acid, hydrochloric acid, hydroiodic acid, or the like can also be used as an aqueous salt solution. Also in this case, solute concentration is preferably 0.005 to 1 mol/L and dissolution temperature is preferably 20°C or higher. The buffer layer can also be formed by applying other conditions similar to the above. After depositing the buffer layer with predetermined thickness, deposition is performed in the above-mentioned manner.

A special case of the method of forming the buffer layer includes a case of using the same material as the crystalline oxide film. In this case, deposition temperature of the buffer layer may be higher than deposition temperature of the crystalline oxide film. For example, the deposition temperature of the buffer layer may be 450°C whereas the deposition temperature of the crystalline oxide film may be 400°C, or the deposition temperature of the buffer layer may be 500°C whereas the deposition temperature of the crystalline oxide film may be 450°C. This can further improve the crystallinity of the crystalline oxide film.

### (Heat Treatment)

Additionally, the laminated structure according to the present invention may be subject to heat treatment at 200 to 600°C. This can further remove unreacted species in the film, thereby obtaining the higher-quality laminated structure. The heat treatment may be performed in air, an oxygen atmosphere, or an inert gas atmosphere such as nitrogen or argon. The heat treatment time can be determined as appropriate, and it can be 5 to 240 minutes, for example.

### (Peeling)

In the laminated structure according to the present invention, the crystalline oxide film may be peeled from the base substrate. A peeling technique is not particularly limited and may be a known technique. Exemplar peeling techniques include peeling off by: applying a mechanical shock; applying heat and using thermal stress; applying vibration such as ultrasonic waves; etching; or the like. By peeling in this manner, it is possible to obtain the crystalline oxide film as a free-standing film.

### (Other Manufacturing Methods)

Although the method of manufacturing the laminated structure according to the present invention is described above citing Mist CVD as an example, it is possible to manufacture the laminated structure according to the present invention using methods other than Mist CVD by controlling the temperature during forming the crystalline oxide film, especially the temperature of the substrate surface. If it is difficult to accurately measure the temperature of the substrate and the like, it is also possible to fabricate a plurality of samples of the laminated structure with varying temperature conditions, and measure a reflectance spectrum to select those having desired properties, thereby obtaining the laminated structure according to the present invention.

### EXAMPLE

Hereinafter, the present invention will be specifically described with reference to Examples. However, the present invention is not limited thereto.

### Example 1

The deposition apparatus 201 used in the present example will be described with reference to FIG. 5. The deposition apparatus 201 has the carrier gas source 202a which supplies the carrier gas, the flow control valve 203a for adjusting the flow rate of the carrier gas sent out from the carrier gas source 202a, the carrier gas source 202b for dilution which supplies the carrier gas for dilution, the flow control valve 203b for adjusting the flow rate of the carrier gas for dilution sent out from the carrier gas source 202b for dilution, the mist source 204 in which the raw material solution 204a is stored, the container 205 in which the water 205a is stored, the ultrasonic transducer 206 attached to the bottom surface of the container 205, the deposition chamber 207 equipped with the heater 208, and the supply pipe 209 made of quartz which connects from the mist source 204 to the deposition chamber 207.

### (Premeasurement of Temperature)

First, deposition conditions were simulatively reproduced using a dummy substrate and water mist, and the temperature of the substrate surface was measured. Specifically, the raw material solution 204a was pure water and the dummy substrate was a c-plane sapphire substrate having a diameter of 4 inches (100 mm). This substrate was placed in the deposition chamber 207, the heater 208 was set at 450°C to raise the temperature, followed by leaving as it is for 30 minutes to stabilize the temperature inside the deposition chamber. Then, the flow control valves 203a, 203b were opened to supply the carrier gases from the carrier gas sources 202a, 202b into the deposition chamber 207. After sufficiently replacing the atmosphere in the deposition chamber 207 with the carrier gases, the flow rates of the carrier gas and the carrier gas for dilution were adjusted to 2 L/min and 6 L/min, respectively. As the carrier gases, compressed air was used. Next, the ultrasonic transducer 206 was vibrated at 2.4 MHz and the vibration thereof propagated through the water 205a to the raw material solution 204a (pure water), thereby atomizing the pure water into mist to generate the mist. This mist was introduced by the carrier gas into the deposition chamber 207 via the supply pipe 209. The temperature at various points inside the deposition chamber at this occasion was measured using a thermocouple. As a result, the temperature of the substrate surface was 424°C, the temperature of a tip of the nozzle was 146°C, and the temperature of a wall surface of the deposition chamber was 43°C.

### (Forming Gallium Oxide Film)

Then, the gallium oxide film was formed. As the substrate 210, a c-plane sapphire substrate of 4 inches (100 mm) was prepared. This substrate was placed in the deposition chamber 207, the heater 208 was set at 450°C to raise the temperature, followed by leaving as it is for 30 minutes to stabilize the temperature inside the deposition chamber including the nozzle.

For the raw material solution 204a, ultrapure water was used as a solvent and gallium bromide was used as a solute. Concentration of gallium in the raw material solution was 0.1 mol/L. This raw material solution 204a was stored in the mist source 204. Then, the flow control valves 203a, 203b were opened to supply the carrier gases from the carrier gas sources 202a, 202b into the deposition chamber 207. After sufficiently replacing the atmosphere in the deposition chamber 207 with the carrier gases, the flow rates of the carrier gas and the carrier gas for dilution were adjusted to 2 L/min and 6 L/min, respectively. Nitrogen was used as the carrier gases.

Next, the ultrasonic transducer 206 was vibrated at 2.4 MHz and the vibration thereof propagated through the water 205a to the raw material solution 204a, thereby atomizing the raw material solution 204a into mist to generate the mist. This mist was introduced by the carrier gas into the deposition chamber 207 via the supply pipe 209, and the mist was subject to thermal reaction on the substrate 210 to form a thin film of gallium oxide on the substrate 210. Deposition time was 30 minutes. The temperature at various points inside the deposition chamber at this occasion was expected to be the temperature obtained by the above premeasurement of the temperature.

### (Evaluation)

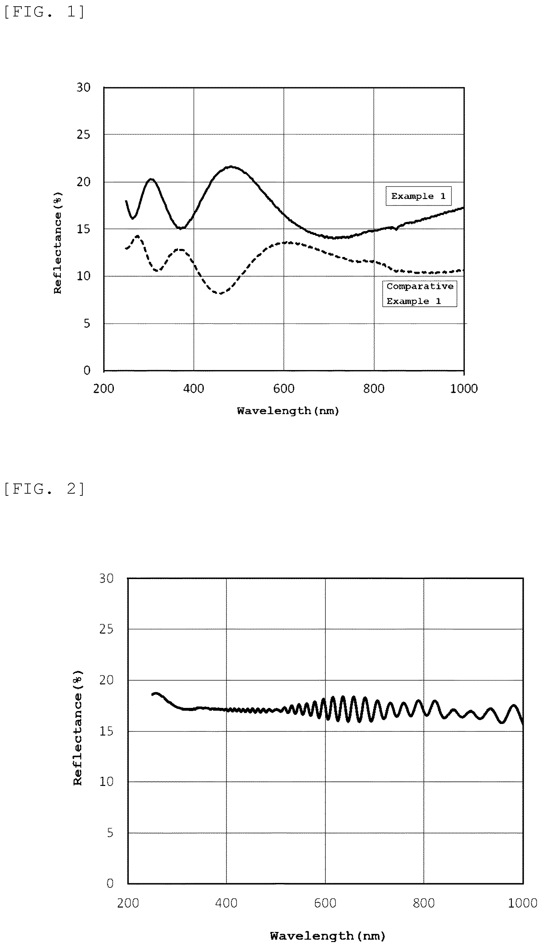

Regarding the thin film formed on the substrate 210, it was confirmed by x-ray diffraction that α-Ga₂O₃ was formed. When measuring a rocking curve of a (006) surface of the α-Ga₂O₃, a half width was 6 seconds, indicating outstanding crystallinity. It should be noted that when measuring the rocking curve, a four-crystal monochromator that combines two channel-cut crystals was used to increase monochromaticity of x-rays, allowing more accurate measurement. Next, a reflectance spectrum on the film formed side of the obtained laminated structure was measured using a V-770 spectrophotometer manufactured by JASCO Corporation. Upon measuring, a sample was attached to an integrating sphere, followed by measuring total reflectance with measurement light at an incident angle of about 5 degrees relative to the sample. In addition, white reflectance standard of barium sulfate was used to obtain a baseline. The result is shown in FIG. 1. The calculated average of reflectance at 400 to 800 nm was 17.1%. Further, when measuring the film thickness using an optical interference type film thickness meter, the film thickness was 179 nm.

### Comparative Example 1

When forming a gallium oxide film similar to the one in Example 1, the heater 208 was set at 500°C and the film was formed without stabilizing the temperature after raising the temperature. Other than this, film forming and evaluation were performed under the same conditions as in Example 1. As a result, the half width of the rocking curve of the (006) plane of α-Ga₂O₃ was 102 seconds, and the crystallinity deteriorated. The reflectance spectrum is shown in FIG. 1 together with the one of Example 1. Decrease in the reflectance was confirmed and the average of reflectance at 400 to 800 nm was 11.6%.

### Example 2

Film forming and evaluation were performed in the same manner as in Example 1 except that an AlGaO film was formed as the buffer layer and the film thickness of gallium oxide was 3 um. The half width of the rocking curve was as good as 15 seconds. The reflectance spectrum is shown in FIG. 2. The average of the reflectance at 400 to 800 nm was 17.1%.

### Example 3

Film forming and evaluation were performed in the same manner as in Example 2 except that the film thickness of gallium oxide was 6 um. The half width of the rocking curve was as good as 18 seconds. The reflectance spectrum is shown in FIG. 3. The average of the reflectance at 400 to 800 nm was 17.0%.

### Example 4

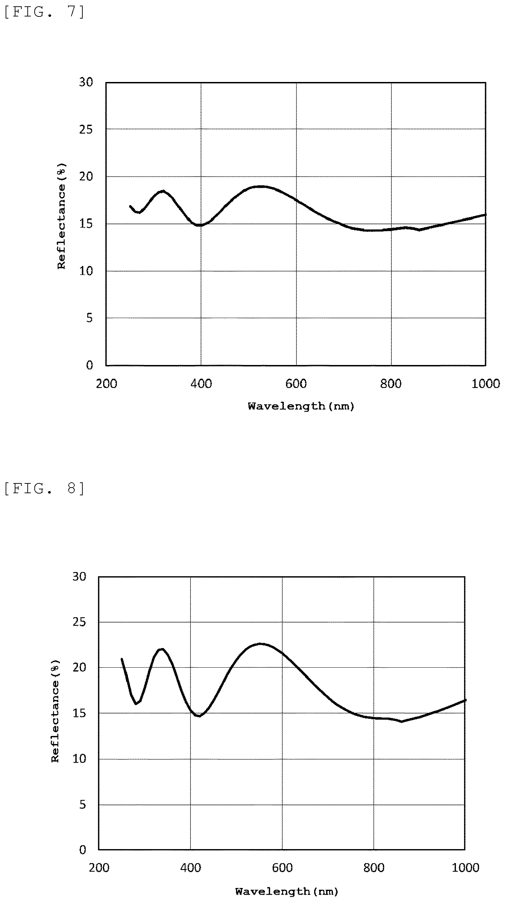

Film forming and evaluation were performed in the same manner as in Example 1 except that the heater 208 was set at 430°C when forming a gallium oxide film similar to the one in Example 1. The half width of the rocking curve was as good as 9 seconds. The reflectance spectrum is shown in Fig. 7. The average of the reflectance at 400 to 800 nm was 16.4%.

### Example 5

Film forming and evaluation were performed in the same manner as in Example 1 except that the heater 208 was set at 550°C when forming a gallium oxide film similar to the one in Example 1. The half width of the rocking curve was as good as 6 seconds. The reflectance spectrum is shown in Fig. 8. The average of the reflectance at 400 to 800 nm was 18.3%.

### Comparative Example 2

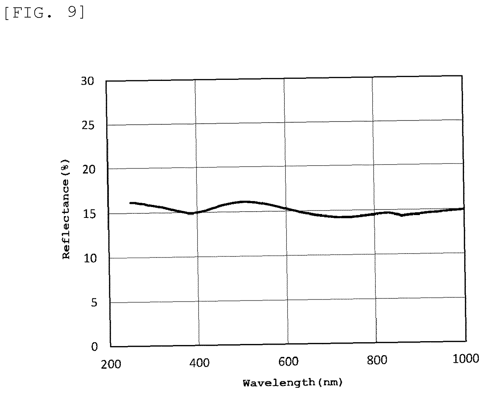

When forming a gallium oxide film similar to the one in Example 1, the heater 208 was set at 550°C and the film was formed without stabilizing the temperature after raising the temperature. Other than this, film forming and evaluation were performed under the same conditions as in Example 1. As a result, the half width of the rocking curve was 88 seconds, and the crystallinity deteriorated. The reflectance spectrum is shown in FIG. 9. The average of the reflectance at 400 to 800 nm was 15.1%.

As described above, when the average of the reflectance at 400 to 800 nm of the obtained laminated structure was high, the crystallinity of the obtained film was excellent. Forming a semiconductor device using the laminated structure according to the present invention is useful for improving the properties of the semiconductor device.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A laminated structure having at least a base substrate and a crystalline oxide film containing gallium oxide as a main component,
wherein an average value of reflectance of light having a wavelength of 400 to 800 nm is 16% or greater on a surface on a side of the crystalline oxide film of the laminated structure.

2. The laminated structure according to claim 1, wherein the base substrate is a single crystal, and the crystalline oxide film is a single crystal or a uniaxially oriented film.

3. The laminated structure according to claim 1 or 2, wherein the base substrate is any of a sapphire substrate, a lithium tantalate substrate, or a lithium niobate substrate.

4. The laminated structure according to any one of claims 1 to 3, wherein the crystalline oxide film has a corundum structure.

5. The laminated structure according to claim 4, wherein the crystalline oxide film having the corundum structure has a half width of an x-ray rocking curve of a (006) plane of 5 to 20 seconds.

6. The laminated structure according to any one of claims 1 to 5, wherein the base substrate has a surface area of 100 mm² or more having the crystalline oxide film, or a diameter of 2 inches (50 mm) or more.

7. A method of forming a crystalline oxide film containing gallium oxide as a main component by Mist CVD, comprising supplying a carrier gas containing mist from a nozzle to a base substrate placed in a deposition chamber,
wherein the film is formed with temperature of the nozzle or an inner wall of the deposition chamber higher than a room temperature.

8. The method of forming a crystalline oxide film according to claim 7, wherein the temperature of the nozzle is 50 to 250°C.

9. A semiconductor device comprising a crystalline oxide film as an insulating thin film or a conductive thin film, the crystalline oxide film containing gallium oxide as a main component,
wherein an average value of reflectance of light having a wavelength of 400 to 800 nm is 16% or greater on a surface on a side of the crystalline oxide film.
